# EUROPÄISCHE PATENTSCHRIFT

(11) **EP 0 838 092 B1**
(45) Veröffentlichungstag und Bekanntmachung des Hinweises auf die Patenterteilung: **07.11.2001**
(21) Anmeldenummer: 96921877.5
(22) Anmeldetag: 02.07.1996
(51) Int. Cl.: H01L 27/115, H01L 21/8247

(54) **ELEKTRISCH SCHREIB- UND LÖSCHBARE FESTWERTSPEICHERZELLENANORDNUNG UND VERFAHREN ZU DEREN HERSTELLUNG**
ELECTRICALLY ERASABLE PROGRAMMABLE ROM MEMORY CELL ARRAY AND A METHOD OF PRODUCING THE SAME
SYSTEME DE CELLULES DE MEMOIRE MORTE PROGRAMMABLE EFFA ABLE ELECTRIQUEMENT ET PROCEDE DE FABRICATION DUDIT SYSTEME

(30) Priorität: 10.07.1995 DE 19525070
(43) Veröffentlichungstag der Anmeldung: 29.04.1998
(73) Patentinhaber: Infineon Technologies AG, 81669 München (DE)
(72) Erfinder: KRAUTSCHNEIDER, Wolfgang, D-83104 Hohenthann (DE)
(74) Vertreter: Zedlitz, Peter, Dipl.-Inf.
(86) Internationale Anmeldenummer: DE9601171
(87) Internationale Veröffentlichungsnummer: WO9703469

(56) Entgegenhaltungen:
- EP-A- 0 673 070
- US-A- 4 814 840
- US-A- 5 306 941

## Beschreibung

Für viele Anwendungen werden Festwertspeicherzellenanordnungen mit elektrisch schreibbaren und elektrisch löschbaren Festwert-Speicherzellen in Siliziumtechnologie, sogenannte Flash-EEPROM, benötigt. Diese Flash-EEPROM-Anordnungen erhalten die gespeicherten Daten auch ohne Spannungsversorgung.

Technisch werden diese Speicherzellen meist durch einen MOS-Transistor realisiert, der auf dem Kanalbereich ein erstes Dielektrikum, ein floatendes Gate, ein zweites Dielektrikum und ein Kontrollgate aufweist. Ist auf dem floatenden Gate eine Ladung gespeichert, so beeinflußt diese die Schwellenspannung des MOS-Transistors. In einer solchen Speicherzellenanordnung wird der Zustand "Ladung auf dem floatenden Gate" einem ersten logischen Wert, der Zustand "keine Ladung auf dem floatenden Gate" einem zweiten logischen Wert zugeordnet. Die Information wird in die Speicherzellen über einen Fowler-Nordheim-Tunnelstrom, durch den Elektronen auf das floatende Gate injiziert werden, eingeschrieben. Gelöscht wird die Information durch einen Tunnelstrom in entgegengesetzter Richtung durch das erste Dielektrikum.

Die MOS-Transistoren sind in derartigen Speicherzellenanordnungen als planare MOS-Transistoren ausgebildet und in einer planaren Zellarchitektur angeordnet. Dadurch beträgt der theoretisch minimale Flächenbedarf einer Speicherzelle 4F², wobei F die kleinste herstellbare Strukturgröße in der jeweiligen Technologie ist. Derzeit werden derartige Flash-EEPROM-Anordnungen für Datenmengen von maximal 64 Mbit angeboten.

Größere Datenmengen können derzeit schreib- und löschbar nur in dynamischen Speicherzellenanordnungen (DRAM) oder auf magnetischen Datenträgern gespeichert werden. Ein DRAM benötigt zur Erhaltung der gespeicherten Daten ständig eine Spannungsversorgung. Magnetische Datenträger dagegen beruhen auf mechanischen Systemen mit rotierenden Speichermedien.

Aus US-PS 4 814 840 ist eine EEPROM-Anordnung bekannt, in der planare MOS-Transistoren mit Floatinggate und Kontrollgate als Speicherzellen verwendet werden. Zwischen benachbarten MOS-Transistoren ist jeweils ein Graben angeordnet. Das Floatinggate überlappt jeweils die Flanken der dem MOS-Transistor benachbarten Gräben.

In der nicht vorveröffentlichten europäischen Patentanmeldung 0 673 070 A2 ist eine EEPROM-Anordnung vorgeschlagen worden, in der Zeilen von in Reihe verschalteten MOS-Transistoren alternierend am Boden von Längsgräben und zwischen benachbarten Längsgräben angeordnet sind. Die MOS-Transistoren weisen Floatinggates und Kontrollgates auf, wobei die Kontrollgates als Bitleitung quer zu den Längsgräben verlaufen.

Der Erfindung liegt das Problem zugrunde, eine elektrisch schreib- und löschbare Festwertspeicherzellenanordnung anzugeben, die mit einem geringeren Flächenbedarf pro Speicherzelle herstellbar ist. Darüber hinaus soll ein Herstellverfahren für eine solche Speicherzellenanordnung angegeben werden.

Dieses Problem wird erfindungsgemäß gelöst durch eine elektrisch schreib- und löschbare Festwertspeicherzellenanordnung gemäß Anspruch 1 sowie ein Verfahren zu deren Herstellung gemäß Anspruch 5. Weitere Ausgestaltungen der Erfindung gehen aus den übrigen Ansprüchen hervor.

Die erfindungsgemäße elektrisch schreib- und löschbare Festwertspeicherzellenanordnung ist in einem Halbleitersubstrat realisiert. Vorzugsweise weist das Halbleitersubstrat mindestens im Bereich der Speicherzellenanordnung monokristallines Silizium auf. Das Halbleitersubstrat kann dabei sowohl aus einer monokristallinen Siliziumscheibe als auch aus einem SOI-Substrat bestehen.

In dem Halbleitersubstrat ist ein von einem ersten Leitfähigkeitstyp dotiertes Gebiet angeordnet, das an eine Hauptfläche des Halbleitersubstrats angrenzt. Das vom ersten Leitfähigkeitstyp dotierte Gebiet ist gegenüber dem Halbleitersubstrat isoliert, so daß an das vom ersten Leitfähigkeitstyp dotierte Gebiet eine Spannung angelegt werden kann. Die Isolation des vom ersten Leitfähigkeitstyps dotierten Gebietes gegenüber dem Halbleitersubstrat kann sowohl in einem pn-Übergang als auch in einer vergrabenen, isolierenden Schicht, zum Beispiel der vergrabenen isolierenden Schicht eines SOI-Substrates, bestehen.

In dem vom ersten Leitfähigkeitstyp dotierten Gebiet sind eine Vielzahl einzelner Speicherzellen angeordnet. Die Speicherzellen sind dabei jeweils in im wesentlichen parallel verlaufenden Zeilen angeordnet. In der Hauptfläche des Halbleitersubstrats sind Längsgräben vorgesehen, die im wesentlichen parallel zu den Zeilen verlaufen. Die Zeilen sind jeweils abwechselnd auf der Hauptfläche zwischen benachbarten Längsgräben und auf dem Boden der Längsgräben angeordnet. Das heißt, die Speicherzellen sind jeweils in zwei Ebenen angeordnet, die in der Höhe gegeneinander versetzt sind.

Jede Speicherzelle umfaßt einen MOS-Transistor mit von einem zweiten, dem ersten entgegengesetzten Leitfähigkeitstyp dotierten Source/Drain-Gebieten, einem ersten Dielektrikum, einem floatenden Gate, einem zweiten Dielektrikum und einem Kontrollgate.

Quer zu den Zeilen verlaufen Wortleitungen, die jeweils mit den Kontrollgates von entlang unterschiedlichen Zeilen angeordneten MOS-Transistoren verbunden sind.

Die MOS-Transistoren von entlang einer Zeile angeordneten Speicherzellen sind in Reihe verschaltet. Miteinander verbundene Source/Drain-Gebiete von entlang einer Zeile benachbarten MOS-Transistoren sind dabei als zusammenhängendes dotiertes Gebiet ausgebildet. Jede Zeile weist zwei Anschlüsse auf, zwischen denen in der Zeile angeordnete MOS-Transistoren in Reihe verschaltet sind. Über diese Anschlüsse können die in der jeweiligen Zeile befindlichen MOS-Transistoren im Sinne einer NAND-Architektur oder mit wahlfreiem Zugriff angesteuert werden. Werden in dieser Ausführungsform die Breite der Längsgräben, der Abstand benachbarter Längsgräben, die Ausdehnung der zusammenhängenden dotierten Gebiete und die Breite der Wortleitungen entsprechend einer in der jeweiligen Technologie minimalen Strukturgröße F ausgebildet, so beträgt der Flächenbedarf pro Speicherzelle 2F². Bei Einsatz einer Technologie mit einer minimalen Strukturgröße F von 0,4 *µ*m ist damit eine Speicherdichte von 6,25 Bit/*µ*m² erzielbar.

Benachbarte Zeilen sind jeweils durch die Flanken der Längsgräben gegeneinander isoliert. Zur Vermeidung von parasitären MOS-Transistoren über die Flanken der Längsgräben werden diese mit isolierenden Spacern versehen.

Zur Verbesserung der Isolationswirkung dieser Spacer liegt es im Rahmen der Erfindung, daß die Längsgräben im Bereich des Grabenbodens durch Ausbuchtungen der Flanken in diesem Bereich eine größere Weite aufweisen als im Bereich der Hauptfläche. Diese Ausbuchtungen sind mit isolierendem Material gefüllt und vergrößern die Dicke des isolierenden Spacers im Bereich des Grabenbodens. Eine andere Möglichkeit zur Erhöhung der Isolation zwischen Hauptfläche und Grabenboden besteht in der Ausbildung einer dünnen hochdotierten p⁺-dotierten Schicht durch Ionenimplantation in Höhe der halben Grabentiefe.

Der Platzbedarf pro Speicherzelle von 2F² wird bei der Herstellung der erfindungsgemäßen Festwertspeicherzellenanordnung unter Einsatz selbst justierender Prozeßschritte erzielt.

Zur Herstellung der erfindungsgemäßen elektrisch schreib- und löschbaren Festwertspeicherzellenanordnung wird zunächst in der Hauptfläche des Halbleitersubstrats das vom ersten Leitfähigkeitstyp dotierte Gebiet erzeugt. In der Hauptfläche werden innerhalb des vom ersten Leitfähigkeitstyp dotierten Gebietes im wesentlichen parallel verlaufende Längsgräben geätzt, deren Länge mindestens so groß wie die Länge der Zeilen ist. Anschließend wird eine erste dielektrische Schicht erzeugt. Es wird ganzflächig eine erste dotierte Polysiliziumschicht erzeugt und so strukturiert, daß streifenförmige erste Polysiliziumstrukturen entstehen, die parallel zu den Längsgräben jeweils an der Hauptfläche zwischen benachbarten Längsgräben und am Boden der Längsgräben angeordnet sind. Es wird eine zweite dielektrische Schicht erzeugt. Durch Abscheiden und anisotropes Ätzen einer zweiten Polysiliziumschicht werden Kontrollgates und quer zu den Zeilen verlaufende Wortleitungen erzeugt. Die Wortleitungen sind jeweils mit den Kontrollgates von entlang unterschiedlichen Zeilen angeordneten MOS-Transistoren verbunden. Die zweite Polysiliziumschicht wird vorzugsweise in einer solchen Dicke abgeschieden, daß die Wortleitungen quer zu den Längsgräben eine planare Oberfläche aufweisen. Anschließend werden die zweite dielektrische Schicht und die ersten Polysiliziumstrukturen durch anisotropes Ätzen entsprechend den Wortleitungen strukturiert. Dies erfolgt zum Beispiel unter Verwendung derselben Maske, mit der die Wortleitungen strukturiert worden sind. Es wird eine Source/Drain-Implantation für die MOS-Transistoren durchgeführt, bei der die Wortleitungen als Maske verwendet werden. Gleichzeitig werden die Wortleitungen bei dieser Implantation dotiert.

Vorzugsweise wird die erste Polysiliziumschicht durch selbstjustierende Prozeßschritte strukturiert. Dabei werden durch Abscheiden und anisotropes Ätzen einer ersten Hilfsschicht Spacer an den Teilen der ersten Polysiliziumschicht, die an den Flanken der Längsgräben angeordnet sind, gebildet. Das anisotrope Ätzen erfolgt dabei selektiv zum Substrat. Die erste Hilfsschicht wird zum Beispiel aus Si₃N₄ oder einem SiO₂, das zu thermischem SiO₂ selektiv ätzbar ist, gebildet. Anschließend wird auf freiliegenden Teilen der ersten Polysiliziumschicht selektiv eine zweite Hilfsschicht erzeugt, zu der die erste Hilfsschicht und die erste Polysiliziumschicht selektiv ätzbar sind, die zweite Hilfsschicht wird zum Beispiel durch thermische Oxidation aus thermischem SiO₂ gebildet. Die Spacer werden dann selektiv zur zweiten Hilfsschicht entfernt. Unter Verwendung der zweiten Hilfsschicht als Ätzmaske wird die erste Polysiliziumstruktur durch Ätzen der ersten Polysiliziumschicht gebildet. Schließlich wird die zweite Hilfsschicht entfernt. Da bei dieser selbstjustierenden Strukturierung der ersten Polysiliziumschicht keine Maske, die relativ zu den Längsgräben justiert werden müßte, eingesetzt wird, kann die Strukturierung der ersten Polysiliziumschicht feiner, als es der in der jeweiligen Technologie minimal herstellbaren Strukturgröße F entspricht, erfolgen.

Zur verbesserten Isolation zwischen benachbarten Zeilen werden vor dem Abscheiden der zweiten dielektrischen Schicht an den Flanken der ersten Polysiliziumstruktur isolierende Spacer gebildet.

Die isolierende Wirkung dieser isolierenden Spacer kann dadurch verbessert werden, daß die Längsgräben so erzeugt werden, daß ihre Flanken im Bereich des Grabenbodens Ausbuchtungen aufweisen, durch die die Weite des Grabens im Bereich des Grabenbodens größer ist als im Bereich der Hauptfläche. Ein solches Grabenprofil kann durch kombiniertes anisotropes und isotropes Ätzen gebildet werden oder durch Ausnutzung des sogenannten Barrelling-Effektes. Unter Barrelling-Effekt wird die Tatsache verstanden, daß es beim anisotropen Plasmaätzen bei erhöhtem Druck zu einer Aufweitung des Grabens im Bereich des Grabenbodens kommt. Der Barrelling-Effekt ist zum Beispiel aus VLSI Electronics, Microstructure Science, Volume 8, Plasma Processing for VLSI, N. G. Einspruch and D. M. Brown, Chapter 5, Academic Press Inc., Orlando, 1984, S. 124 ff. bekannt. Die Ausbuchtungen werden nach der Bildung der ersten dielektrischen Schicht mit isolierendem Material aufgefüllt.

Im folgenden wird die Erfindung anhand eines Ausführungsbeispiels und der Figuren näher erläutert.
- Figur 1: zeigt ein Halbleitersubstrat mit einem von einem ersten Leitfähigkeitstyp dotierten Gebiet, parallel verlaufenden Längsgräben, einer ersten dielektrischen Schicht, einer ersten Polysiliziumschicht und Si₃N₄-Spacern.
- Figur 2: zeigt das Halbleitersubstrat nach Bildung einer zweiten Hilfsschicht durch thermische Oxidation.
- Figur 3: zeigt das Halbleitersubstrat nach selektiver Entfernung der Si₃N₄-Spacer und nach Strukturierung der ersten Polysiliziumschicht.
- Figur 4: zeigt das Halbleitersubstrat nach Entfernen der zweiten Hilfsschicht und nach Abscheidung und Strukturierung einer zweiten dielektrischen Schicht und einer zweiten Polysiliziumschicht.
- Figur 5: zeigt das Halbleitersubstrat nach Bildung von Kontrollgates und Wortleitungen sowie nach Bildung der Source/Drain-Gebiete.
- Figur 6: zeigt den in Figur 5 mit VI-VI bezeichneten Schnitt.
- Figur 7: zeigt den in Figur 5 mit VII-VII bezeichneten Schnitt.
- Figur 8: zeigt eine Aufsicht auf das Halbleitersubstrat.

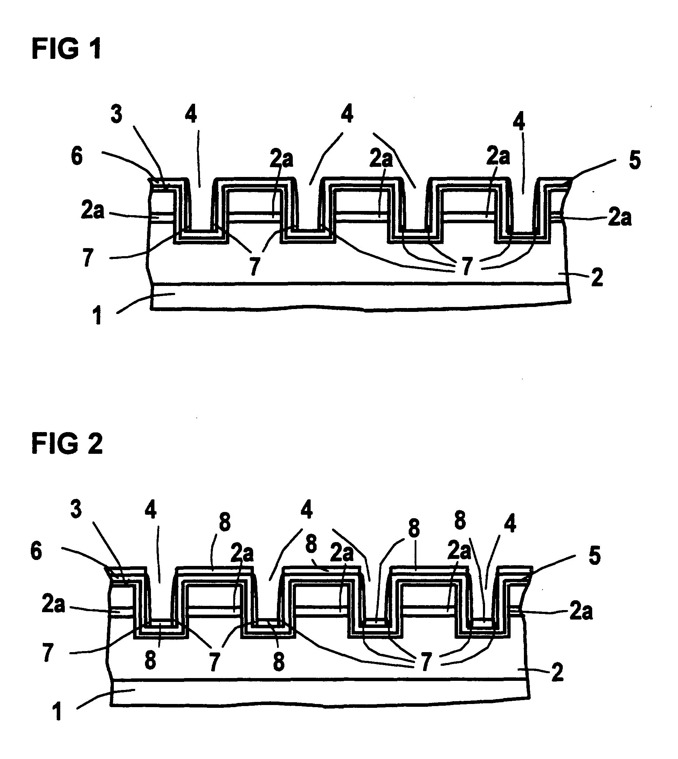

In einem Substrat 1 aus zum Beispiel monokristallinem Silizium mit einer p-Dotierung von 10¹⁶ cm⁻³ wird zunächst eine p-dotierte Wanne 2, zum Beispiel durch maskierte Implantation, erzeugt. Die p-dotierte Wanne 2 weist eine Dotierstoffkonzentration von zum Beispiel 10¹⁷ cm⁻³ auf. Die p-dotierte Wanne 2 grenzt an eine Hauptfläche 3 des Substrats 1 an (siehe Figur 1). Sie weist eine Tiefe von zum Beispiel 1,2 *µ*m auf.

In der p-dotierten Wanne 2 wird durch eine Implantation mit Bor eine p⁺-dotierte Schicht 2a erzeugt. In der p⁺-dotierten Schicht 2a wird eine Dotierstoffkonzentration von zum Beispiel 2 · 10¹⁸ cm⁻³ eingestellt.

Durch Abscheidung einer SiO₂-Schicht in einem TEOS-Verfahren und deren photolithographische Strukturierung wird eine Grabenmaske erzeugt (nicht dargestellt). Durch anisotropes Ätze: zum Beispiel mit C12 werden unter Verwendung der Grabenmaske als Ätzmaske Längsgräben 4 geätzt. Die Längsgräben 4 weisen eine Tiefe von zum Beispiel 0,4 *µ*m auf. Dabei liegt der Grabenboden der Längsgräben 4 in der p-dotierten Wanne 2. Die Breite der Längsgräben 4 beträgt zum Beispiel 0,4 *µ*m, die Länge zum Beispiel 25 *µ*m. Die Längsgräben 4 verlaufen parallel über das Substrat 1. Ihre Ausdehnung und Anzahl ist so groß, daß sie den Bereich für später herzustellende Speicher zellen überdecken. Es werden zum Beispiel 1024 Längsgräben nebeneinander angeordnet.

Anschließend wird eine dielektrische Schicht 5 durch thermische Oxidation aus SiO₂ gebildet. Die erste dielektrische Schicht 5 wird in einer Dicke von zum Beispiel 8 nm gebildet Die Dicke der ersten dielektrischen Schicht 5 ist dabei so bemessen, daß durch Spannungen von 10 Volt bis 15 Volt Tunnelströme hervorgerufen werden können, die innerhalb von Mikrosekunden bis wenigen Millisekunden so viel Ladung auf ein später herzustellendes, floatendes Gate übertragen, daß bei dem darunter befindlichen MOS-Transistor die Schwellenspannung Vₜ die Versorgungsspannung V_{dd} übersteigt.

Nachfolgend wird eine erste Polysiliziumschicht 6 in einer Dicke von zum Beispiel 100 nm bis 200 nm abgeschieden. Die erste Polysiliziumschicht 6 wird n-dotiert. Dieses kann entweder in situ während des Abscheidens erfolgen oder nach dem Abscheiden durch eine Phosphordiffusion. Die erste Polysiliziumschicht 6 weist eine im wesentlichen konforme Kantenbedeckung auf, so daß deren Dicke auf der Hauptfläche 3 und am Grabenboden im wesentlichen gleich groß ist wie an den Flanken der Längsgräben 4 (siehe Figur 1).

Auf die dotierte erste Polysiliziumschicht 6 wird eine Si₃N₄-Schicht 7 in einer Dicke von zum Beispiel 20 nm bis 80 nm aufgebracht. Die Si₃N₄-Schicht weist eine im wesentlichen konforme Kantenbedeckung auf. Es wird eine anisotrope Ätzung zum Beispiel mit CHF₃ durchgeführt, bei der die in den planaren Bereichen angeordneten Teile der Si₃N₄-Schicht entfernt werden. Dabei entstehen Si₃N₄-Spacer 7, die im Bereich der Flanken der Längsgräben 4 die erste Polysiliziumschicht 6 bedecken (siehe Figur 1).

Durch eine thermische Oxidation zum Beispiel bei 850°C wird an der freiliegenden Oberfläche der ersten Polysiliziumschicht 6 selektiv eine SiO₂-Struktur 8 erzeugt (siehe Figur 2). Da nach der Bildung der Si₃N₄-Spacer 7 die erste Polysiliziumschicht 6 im Bereich der Hauptfläche 3 und am Boden der Längsgräben 7 freigelegt wurde, bedeckt die SiO₂-Struktur 8 die erste Polysiliziumschicht 6 im Bereich der Hauptfläche 3 und am Boden der Längsgräben 4.

Nachfolgend werden die Si₃N₄-Spacer 7 selektiv zu der SiO₂-Schicht 8 entfernt. Dieses erfolgt zum Beispiel naßchemisch mit Hilfe von heißer Phosphorsäure. Dabei werden die im Bereich der Flanken der Längsgräben 4 angeordneten Teile der ersten Polysiliziumschicht 6 freigelegt.

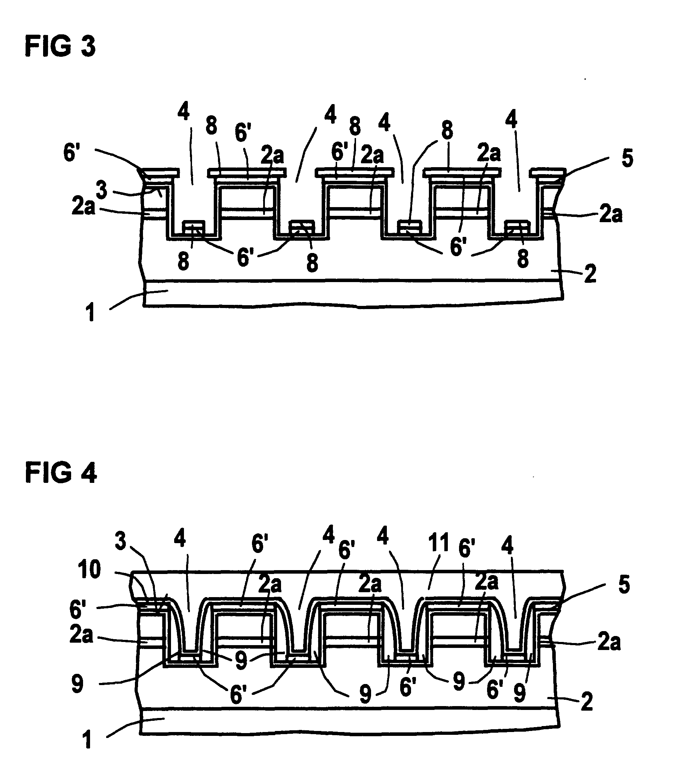

Unter Verwendung der SiO₂-Struktur 8 als Ätzmaske wird die erste Polysiliziumschicht 6 durch eine trockene Ätzung, die mit einer nassen Ätzung kombiniert werden kann, strukturiert. Dabei entsteht eine erste Polysiliziumstruktur 6'. Die Ätzung erfolgt zum Beispiel mit Cl₂ oder mit HF/HNO₃. Bei der Strukturierung der ersten Polysiliziumschicht 6 werden diejenigen Teile der ersten Polysiliziumschicht 6 entfernt, die im Bereich der Flanken der Längsgräben 4 angeordnet sind. Die erste Polysiliziumstruktur 6' umfaßt daher streifenförmige Teile, die jeweils im Bereich der Hauptfläche zwischen benachbarten Längsgräben 4 sowie am Boden der Längsgräben angeordnet sind (siehe Figur 3). Die Bildung der ersten Polysiliziumstruktur 6' erfolgt selbstjustierend, das heißt ohne Einsatz von Photolithographie.

Durch eine trockene Ätzung, zum Beispiel mit CF₄ wird die SiO₂-Struktur 8 entfernt. Die Ätzung erfolgt vorzugsweise selektiv zu Polysilizium.

Durch Abscheiden einer SiO₂-Schicht mit Hilfe eines TEOS-Verfahrens in einer Dicke von zum Beipiel 30 nm bis 100 nm und anschließendes anisotropes Ätzen der SiO₂-Schicht sowie Rückätzen um die Dicke der ersten Polysiliziumschicht werden SiO₂-Spacer 9 gebildet (siehe Figur 4). Die Ätzung erfolgt zum Beispiel mit CF₄. Die SiO₂-Spacer 9 sind im Bereich der Flanken der Längsgräben 4 angeordnet. Sie bedecken ebenfalls den freigelegten Bereich am Boden der Längsgräben 4.

Nach einer Vorbehandlung der Oberfläche der ersten Polysiliziumstruktur 6' zum Beispiel durch eine reduzierende Reinigung mit HF wird eine zweite dielektrische Schicht 10 erzeugt. Die zweite dielektrische Schicht 10 wird zum Beispiel durch thermische Oxidation einer Schicht aus SiO₂ in einer Schichtdicke von zum Beispiel 14 nm gebildet. Alternativ wird die zweite dielektrische Schicht 10 als Mehrfachschicht mit einer SiO₂-Si₃N₄-SiO₂-Schichtenfolge gebildet. Dazu wird zunächst eine SiO₂-Schicht in einer Schichtdicke von zum Beispiel 5 nm abgeschieden. Darauf wird eine Si₃N₄-Schicht in einer Schichtdicke von zum Beispiel 7 nm abgeschieden. Abschließend wird durch thermische Oxidation eine weitere SiO₂-Schicht in einer Schichtdicke von zum Beispiel 5 nm gebildet. Eine weitere Möglichkeit für ein geeignetes zweites Dielektrikum besteht in der Verwendung von nitridiertem Oxid.

Anschließend wird eine zweite Polysiliziumschicht 11 abgeschieden (siehe Figur 4). Die zweite Polysiliziumschicht 11 wird in einer Dicke, die größer als die halbe Breite der Längsgräben 4 ist, gebildet. Dadurch weist die zweite Polysiliziumschicht 11 eine im wesentlichen planare Oberfläche auf. Die zweite Polysiliziumschicht 11 wird in einer Dicke von zum Beispiel 300 nm gebildet.

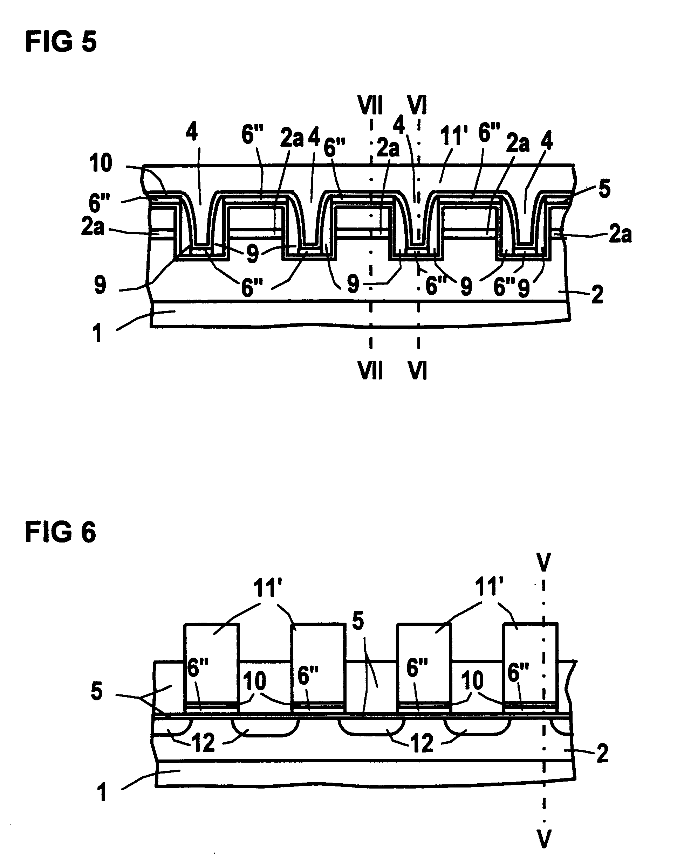

Nach Bildung einer Photolackmaske (nicht dargestellt) wird die zweite Polysiliziumschicht 11 durch anisotropes Ätzen strukturiert. Dabei werden Wortleitungen 11' gebildet, die quer zu den Längsgräben 4 verlaufen. Die anisotrope Ätzung der zweiten Polysiliziumschicht 11 erfolgt zum Beispiel mit Cl₂. Durch Änderung des Ätzmediums in CF₄ wird mit derselben Photolackmaske die zweite dielektrische Schicht 10 strukturiert. Durch erneute Änderung des Ätzmediums zu Cl₂ wird die erste Polysiliziumstruktur 6' strukturiert, wobei die Oberfläche der ersten dielektrischen Schicht 5 und der SiO₂-Spacer 9 freigelegt wird (siehe Figur 5). Die Wortleitungen 11' werden in einer Breite von zum Beispiel 0,4 *µ*m und mit einem Abstand zwischen benachbarten Wortleitungen 11' von ebenfalls zum Beispiel 0,4 *µ*m gebildet.

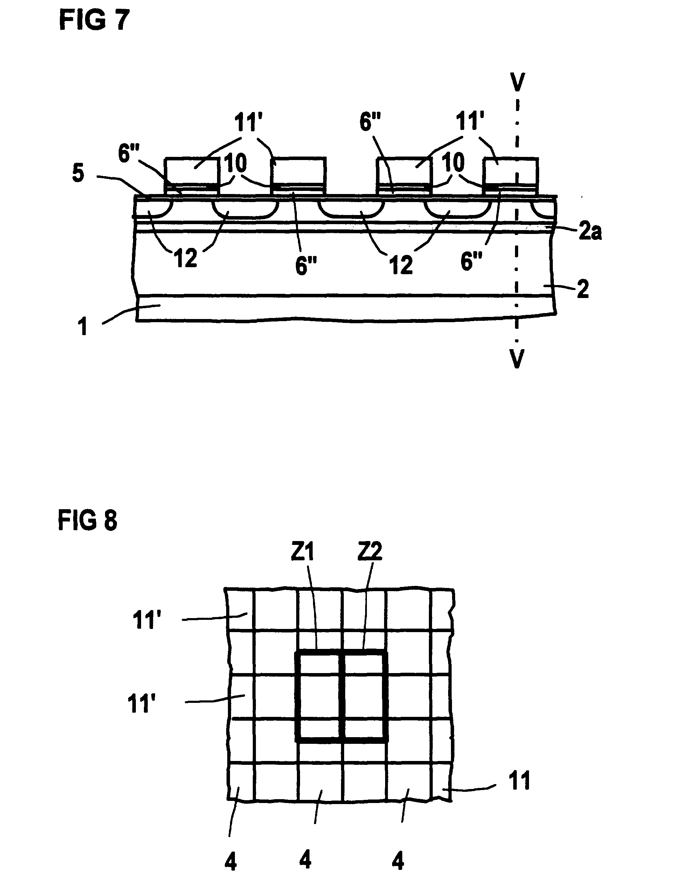

Nach Entfernen der Photolackmaske wird eine Source/Drain-Implantation mit zum Beispiel Arsen und einer Energie von zum Beispiel 25 keV und einer Dosis von zum Beispiel 5 x 10¹⁵ cm⁻² durchgeführt. Bei der Source/Drain-Implantation werden am Boden der Längsgräben 4 sowie in der Hauptfläche 3 zwischen den Längsgräben 4 dotierte Gebiete 12 erzeugt (siehe Figur 5, Figur 6, die den mit VI-VI bezeichneten Schnitt durch Figur 5 darstellt, und Figur 7, die den mit VII-VII bezeichneten Schnitt in Figur 5 darstellt. Der in Figur 5 dargestellte Schnitt ist in Figur 6 und Figur 7 jeweils mit V-V bezeichnet). Die dotierten Gebiete 12 wirken jeweils als gemeinsames Source/Drain-Gebiet für zwei entlang einer Zeile angeordnete, benachbarte MOS-Transistoren. Bei der Source/Drain-Implantation werden gleichzeitig die Wortleitungen 11' dotiert.

Die Speicherzellenanordnung wird durch Abscheidung eines Zwischenoxids, in dem mit Hilfe photolithographischer Prozeßschritte Kontaktlöcher geöffnet werden, und Bildung von Kontakten durch Aufbringen einer Metallschicht zum Beispiel durch Sputtern und anschließendes Strukturieren der Metallschicht fertiggestellt.

Dabei wird jede Zeile am Rand der Festwertspeicherzellenanordnung mit zwei Anschlüssen versehen, zwischen den die in der Zeile angeordneten MOS-Transistoren in Reihe verschaltet sind (nicht dargestellt).

Bei der Strukturierung der ersten Polysiliziumstruktur 6' entstehen floatende Gates 6", die jeweils unterhalb einer Wortleitung 11' angeordnet sind.

Je zwei benachbarte dotierte Gebiet 12 und die dazwischen angeordnete Wortleitung 11' bilden jeweils einen MOS-Transistor. Der zwischen den beiden dotierten Gebieten 12 angeordnete Teil der p-dotierten Wanne 2 bildet dabei den Kanalbereich des MOS-Transistors. Oberhalb des Kanalbereichs ist die erste dielektrische Schicht 5 als Tunneloxid, das floatende Gate 6", das zweite Dielektrikum 10 sowie ein Kontrollgate, das aus dem oberhalb des Kanalbereichs verlaufenden Teils der Wortleitung 11' gebildet wird, angeordnet.

Am Boden der Längsgräben 4 sowie zwischen den Längsgräben 4 im Bereich der Hauptfläche 3 ist jeweils eine Zeile von in Reihe verschalteten MOS-Transistoren, die jeweils aus zwei dotierten Gebieten 12 und der dazwischen angeordneten Wortleitung 11' gebildet sind, angeordnet. Die am Boden eines Längsgrabens 4 angeordneten MOS-Transistoren sind von den benachbarten, zwischen den Längsgräben 4 an der Hauptfläche angeordneten MOS-Transistoren durch den SiO₂-Spacer 9 isoliert.

Die maximale Isolationsspannung ist dabei durch die Ausdehnung des SiO₂-Spacers 9 parallel zur Hauptfläche gegeben. Zur Verbesserung der Isolation kann diese Ausdehnung des SiO₂-Spacers 9 dadurch vergrößert werden, daß im Bereich des Grabenbodens die Flanken der Längsgräben 4 eine Ausbuchtung (nicht dargestellt) aufweisen, die ebenfalls mit SiO₂ aufgefüllt ist. Eine derartige Ausbuchtung läßt sich selbstjustiert dadurch herstellen, daß bei der Ätzung der Längsgräben 4 der Barrelling-Effekt ausgenutzt wird. Nach der Erzeugung der ersten dielektrischen Schicht 5 werden die Ausbuchtungen durch Abscheiden und anisotropes Rückätzen einer zusätzlichen TEOS-SiO₂-Schicht mit einer Schichtdicke von etwa 20 nm bis 80 nm aufgefüllt.

Die Breite der Längsgräben 4, der Abstand zwischen benachbarten Längsgräben 4, die Breite der Wortleitungen 11' sowie der Abstand zwischen benachbarten Wortleitungen 11' wird jeweils vorzugsweise mit einer Abmessung entsprechend einer in der jeweiligen Technologie minimal herstellbaren Strukturgröße F gebildet. Berücksichtigt man, daß jedes der dotierten Gebiete 12 Source/Drain-Gebiet für zwei angrenzende MOS-Transistoren ist, so beträgt die Länge jedes MOS-Transistors parallel zum Verlauf der Längsgräben 4 2F. Die Breite der MOS-Transistoren beträgt jeweils F. Herstellungsbedingt beträgt die Fläche für eine aus einem MOS-Transistor gebildete Speicherzelle daher 2F². Entlang einer Wortleitung 11' benachbarte Speicherzellen, deren Konturen Z1, Z2 in der Aufsicht in Figur 8 als verstärkte Linie eingezeichnet sind, grenzen in der Projektion auf die Hauptfläche 3 unmittelbar aneinander. Die Speicherzelle Z1 ist am Boden eines der Längsgräben angeordnet, die Speicherzelle Z2 dagegen auf der Hauptfläche 3 zwischen zwei benachbarten Längsgräben 4. Durch die in der Höhe versetzte Anordnung benachbarter Speicherzellen wird die Pakkungsdichte erhöht, ohne daß die Isolation zwischen benachbarten Speicherzellen verschlechtert würde.

Die Programmierung der elektrisch schreib- und löschbaren Festwertspeicherzellenanordnung erfolgt durch Injektion von Elektronen vom Kanalbereich des jeweiligen MOS-Transistors auf das zugehörige floatende Gate 6". Je nach auf dem floatenden Gate 6" befindlicher elektrischer Ladung weist der entsprechende MOS-Transistor eine niedrige oder eine hohe Schwellenspannung auf. Eine hohe Schwellenspannung, die einem ersten logischen Wert zugeordnet wird, wird durch eine positive Spannung von zum Beispiel 10 bis 15 Volt hervorgerufen, die zwischen die als Kontrollgate wirkende Wortleitung 11' und die p-dotierte Wanne 2, die gegen das Substrat 1 durch einen pn-Übergang isoliert ist, angelegt wird. Diese Spannung bewirkt, daß über einen Fowler-Nordheim-Tunnelstrom Elektronen auf das floatende Gate injziert werden.

Ein zweiter logischer Wert wird einer niedrigen Schwellenspannung zugeordnet. Dazu wird das entsprechende floatende Gate 6" entladen. Dieses erfolgt durch Anlegen eines negativen Potentials von - 10 bis - 15 Volt zwischen die p-dotierte Wanne 2 und das Kontrollgate 11'. Dadurch wird ein Tunnelstrom durch die erste dielektrische Schicht 5 bewirkt, über den die Elektronen von dem floatenden Gate 6" innerhalb von Mikrosekunden bis wenigen Millisekunden abfließen.

Durch Verwendung mehrerer Spannungsniveaus bei der Injektion von Elektronen auf das floatende Gate 6'' kann die elektrisch schreib- und löschbare Speicherzellenanordnung auch im Sinne einer Mehrwehrlogik programmiert werden.

### Bezugszeichenliste

- 1: Substrat
- 2: p-dotierte Wanne
- 2a: hochdotierte p⁺-dotierte Schicht
- 3: Hauptfläche
- 4: Längsgräben
- 5: erste dielektrische Schicht
- 6: erste Polysiliziumschicht
- 6': erste Polysiliziumstruktur
- 6": floatende Gates
- 7: Si₃N₄-Spacer
- 8: SiO₂ - Struktur
- 9: SiO₂-Spacer
- 10: zweite dielektrische Schicht
- 11: zweite Polysiliziumschicht
- 11': Wortleitungen
- 12: dotierte Gebiete

## Patentansprüche (Patentansprüche für folgende(n) Vertragsstaat(en): IT)

1. Elektrisch schreib- und löschbare Festwertspeicherzellenanordnung,
- bei der eine Vielzahl einzelner Speicherzellen in einem von einem ersten Leitfähigkeitstyp dotierten Gebiet (2) eines Halbleitersubstrats (1) vorgesehen sind,
- bei der das vom ersten Leitfähigkeitstyp dotierte Gebiet (2) gegenüber dem Halbleitersubstrat (1) isoliert ist,
- bei der die Speicherzellen jeweils in im wesentlichen parallel verlaufenden Zeilen angeordnet sind,
- bei der in einer Hauptfläche (3) des Halbleitersubstrats (1) Längsgräben (4) vorgesehen sind, die im wesentlichen parallel zu den Zeilen verlaufen,
- bei der die Zeilen jeweils abwechselnd auf der Hauptfläche (3) zwischen benachbarten Längsgräben (4) und auf dem Boden der Längsgräben (4) angeordnet sind,
- bei der die Speicherzellen jeweils mindestens einen MOS-Transistor mit von einem zweiten, dem ersten entgegengesetzten Leitfähigkeitstyp dotierten Source/Drain-Gebieten (12), einem ersten Dielektrikum (5), einem floatenden Gate (6"), einem zweiten Dielektrikum (10) und einem Kontrollgate (11') umfassen,
- bei der die MOS-Transistoren entlang einer Zeile von angeordneten Speicherzellen in Reihe verschaltet sind,
- bei der quer zu den Zeilen Wortleitungen (11') verlaufen, die jeweils mit den Kontrollgates an entlang unterschiedlichen Zeilen angeordneten MOS-Transistoren verbunden sind.

2. Festwertspeicherzellenanordnung nach Anspruch 1,
bei der zur Isolation zwischen benachbarten Zeilen in Höhe der halben Grabentiefe eine hochdotierte p⁺-dotierte Schicht (2a) vorgesehen ist.

3. Festwertspeicherzellenanordnung nach Anspruch 1 oder 2,
- bei der miteinander verbundene Source/Drain-Gebiete von entlang einer Zeile benachbarten MOS-Transistoren als zusammenhängendes dotiertes Gebiet (12) im Halbleitersubstrat (1) ausgebildet sind,
- bei der jede Zeile zwei Anschlüsse aufweist, zwischen denen die in der Zeile angeordneten MOS-Transistoren in Reihe verschaltet sind.

4. Festwertspeicherzellenanordnung nach einem der Ansprüche 1 bis 3,
bei der die Flanken der Längsgräben (4) im Bereich des Grabenbodens Ausbuchtungen aufweisen, die mit isolierendem Material aufgefüllt sind.

5. Festwertspeicherzellenanordnung nach einem der Ansprüche 1 bis 4,
- bei der das Halbleitersubstrat (1) mindestens im Bereich des vom ersten Leitfähigkeitstyp dotierten Gebietes (2) monokristallines Silizium aufweist,
- bei der das erste Dielektrikum (5) jeweils als SiO₂-Schicht ausgebildet ist,
- bei der das zweite Dielektrikum (10) jeweils SiO₂ und/oder Si₃N₄ enthält,
- bei der das floatende Gate (6'') und das Kontrollgate (11') jeweils dotiertes Polysilizium enthalten.

6. Verfahren zur Herstellung einer elektrisch schreib- und löschbaren Festwertspeicherzellenanordnung,
- bei dem in einer Hauptfläche (3) eines Halbleitersubstrates (1) ein von einem ersten Leitfähigkeitstyp dotiertes Gebiet (2) erzeugt wird, das gegenüber dem Halbleitersubstrat (1) isoliert ist,
- bei dem in der Hauptfläche (3) innerhalb des vom ersten Leitfähigkeitstyp dotierten Gebietes (2) im wesentlichen parallel verlaufende Längsgräben (4) geätzt werden,
- bei dem eine Vielzahl in Zeilen angeordneter Speicherzellen, die jeweils mindestens einen MOS-Transistor mit von einem zweiten, dem ersten entgegengesetzten Leitfähigkeitstyp dotierten Source/Drain-Gebieten (12), einein ersten Dielektrikum (5), einem floatenden Gate (6"), einem zweiten Dielektrikum (10) und einem Kontrollgate (11') umfassen, erzeugt werden, wobei die Zeilen abwechselnd an der Hauptfläche (3) zwischen benachbarten Längsgräben (4) und am Boden der Längsgräben (4) angeordnet sind und wobei die MOS-Transistoren von entlang einer Zeile angeordneten Speicherzellen in Reihe verschaltet sind,
- bei dem eine erste dielektrische Schicht (5) erzeugt wird,
- bei dem eine erste dotierte Polysiliziumschicht (6) erzeugt und so strukturiert wird, daß streifenförmige erste Polysiliziumstrukturen (6') entstehen, die parallel zu den Längsgräben (4) jeweils an der Hauptfläche (3) zwischen benachbarten Längsgräben (4) und am Boden der Längsgräben (4) angeordnet sind,
- bei dem eine zweite dielektrische Schicht (10) erzeugt wird,
- bei dem durch Abscheiden und anisotropes Ätzen einer zweiten Polysiliziumschicht (11) Kontrollgates (11') und quer zu den Zeilen verlaufende Wortleitungen (11') erzeugt werden, die jeweils mit den Kontrollgates von entlang unterschiedlichen Zeilen angeordneten MOS-Transistoren verbunden sind,
- bei dem die zweite dielektrische Schicht (10) und die erste Polysiliziumstruktur (6') durch anisotropes Ätzen entsprechend den Wortleitungen (11') strukturiert werden,
- bei dem eine Source/Drain-Implantation für die MOS-Transistoren durchgeführt wird, bei der die Wortleitungen (11') als Maske wirken.

7. Verfahren nach Anspruch 6,
- bei dem zur selbstjustierten Strukturierung der ersten Polysiliziumschicht (6) durch Abscheiden und zum Halbleitersubstrat (1) selektives, anisotropes Ätzen einer ersten Hilfsschicht Spacer (7) an den an den Flanken der Längsgräben (4) angeordneten Teilen der ersten Polysiliziumschicht (6) gebildet werden,
- bei dem auf freiliegenden Teilen der ersten Polysiliziumschicht (6) selektiv eine zweite Hilfsschicht (8) erzeugt wird, zu der die erste Hilfsschicht (7) und die erste Polysiliziumschicht (6) selektiv ätzbar sind,
- bei dem die Spacer (7) selektiv zur zweiten Hilfsschicht (8) entfernt werden,
- bei dem die erste Polysiliziumstruktur (6') durch Ätzen der ersten Polysiliziumschicht (6) unter Verwendung der zweiten Hilfsschicht (8) als Ätzmaske gebildet wird,
- bei dem die zweite Hilfsschicht (8) entfernt wird.

8. Verfahren nach Anspruch 7,
bei dem die zweite Hilfsschicht (8) aus thermischem SiO₂ und die erste Hilfsschicht aus Si₃N₄ oder aus SiO₂, das zu thermischem SiO₂ selektiv ätzbar ist, gebildet werden.

9. Verfahren nach einem der Ansprüche 5 bis 8,
- bei dem die Längsgräben (4) so erzeugt werden, daß ihre Flanken im Bereich des Grabenbodens Ausbuchtungen aufweisen, durch die die Weite des Grabens (4) im Bereich des Grabenbodens größer ist als im Bereich der Hauptfläche (3),
- bei dem die Ausbuchtungen mit isolierendem Material aufgefüllt werden.

10. Verfahren nach Anspruch 9,
bei dem die Längsgräben (4) durch kombiniertes anisotropes und isotropes Ätzen gebildet werden.

## Patentansprüche (Patentansprüche für folgende(n) Vertragsstaat(en): DE, FR, GB)

1. Elektrisch schreib- und löschbare Festwertspeicherzellenanordnung,
- bei der eine Vielzahl einzelner Speicherzellen in einem von einem ersten Leitfähigkeitstyp dotierten Gebiet (2) eines Halbleitersubstrats (1) vorgesehen sind,
- bei der das vom ersten Leitfähigkeitstyp dotierte Gebiet (2) gegenüber dem Halbleitersubstrat (1) isoliert ist,
- bei der die Speicherzellen jeweils in im wesentlichen parallel verlaufenden Zeilen angeordnet sind,
- bei der in einer Hauptfläche (3) des Halbleitersubstrats (1) Längsgräben (4) vorgesehen sind, die im wesentlichen parallel zu den Zeilen verlaufen, und deren Flanken im Bereich des Grabenbodens Ausbuchtungen aufweisen, die mit isolierendem Material aufgefüllt sind,
- bei der die Zeilen jeweils abwechselnd auf der Hauptfläche (3) zwischen benachbarten Längsgräben (4) und auf dem Boden der Längsgräben (4) angeordnet sind,
- bei der die Speicherzellen jeweils mindestens einen MOS-Transistor mit von einem zweiten, dem ersten entgegengesetzten Leitfähigkeitstyp dotierten Source/Drain-Gebieten (12), einem ersten Dielektrikum (5), einem floatenden Gate (6"), einem zweiten Dielektrikum (10) und einem Kontrollgate (11') umfassen,
- bei der die MOS-Transistoren von entlang einer Zeile angeordneten Speicherzellen in Reihe verschaltet sind,
- bei der quer zu den Zeilen Wortleitungen (11') verlaufen, die jeweils mit den Kontrollgates an entlang unterschiedlichen Zeilen angeordneten MOS-Transistoren verbunden sind.

2. Festwertspeicherzellenanordnung nach Anspruch 1,
bei der zur Isolation zwischen benachbarten Zeilen in Höhe der halben Grabentiefe eine hochdotierte p⁺-dotierte Schicht (2a) vorgesehen ist.

3. Festwertspeicherzellenanordnung nach Anspruch 1 oder 2,
- bei der miteinander verbundene Source/Drain-Gebiete von entlang einer Zeile benachbarten MOS-Transistoren als zusammenhängendes dotiertes Gebiet (12) im Halbleitersubstrat (1) ausgebildet sind,
- bei der jede Zeile zwei Anschlüsse aufweist, zwischen denen die in der Zeile angeordneten MOS-Transistoren in Reihe verschaltet sind.

4. Festwertspeicherzellenanordnung nach einem der Ansprüche 1 bis 3,
- bei der das Halbleitersubstrat (1) mindestens im Bereich des vom ersten Leitfähigkeitstyp dotierten Gebietes (2) monokristallines Silizium aufweist,
- bei der das erste Dielektrikum (5) jeweils als SiO₂-Schicht ausgebildet ist,
- bei der das zweite Dielektrikum (10) jeweils SiO₂ und/oder Si₃N₄ enthält,
- bei der das floatende Gate (6") und das Kontrollgate (11') jeweils dotiertes Polysilizium enthalten.

5. Verfahren zur Herstellung einer elektrisch schreib- und löschbaren Festwertspeicherzellenanordnung,
- bei dem in einer Hauptfläche (3) eines Halbleitersubstrates (1) ein von einem ersten Leitfähigkeitstyp dotiertes Gebiet (2) erzeugt wird, das gegenüber dem Halbleitersubstrat (1) isoliert ist,
- bei dem in der Hauptfläche (3) innerhalb des vom ersten Leitfähigkeitstyp dotierten Gebietes (2) im wesentlichen parallel verlaufende Längsgräben (4) geätzt werden,
- bei dem die Längsgräben (4) so erzeugt werden, daß ihre Flanken im Bereich des Grabenbodens Ausbuchtungen aufweisen, durch die die Weite des Grabens (4) im Bereich des Grabenbodens größer ist als im Bereich der Hauptfläche (3),
- bei dem die Ausbuchtungen mit isolierendem Material aufgefüllt werden,
- bei dem eine Vielzahl in Zeilen angeordneter Speicherzellen, die jeweils mindestens einen MOS-Transistor mit von einem zweiten, dem ersten entgegengesetzten Leitfähigkeitstyp dotierten Source/Drain-Gebieten (12), einem ersten Dielektrikum (5), einem floatenden Gate (6"), einem zweiten Dielektrikum (10) und einem Kontrollgate (11') umfassen, erzeugt werden, wobei die Zeilen abwechselnd an der Hauptfläche (3) zwischen benachbarten Längsgräben (4) und am Boden der Längsgräben (4) angeordnet sind und wobei die MOS-Transistoren von entlang einer Zeile angeordneten Speicherzellen in Reihe verschaltet sind,
- bei dem eine erste dielektrische Schicht (5) erzeugt wird,
- bei dem eine erste dotierte Polysiliziumschicht (6) erzeugt und so strukturiert wird, daß streifenförmige erste Polysiliziumstrukturen (6') entstehen, die parallel zu den Längsgräben (4) jeweils an der Hauptfläche (3) zwischen benachbarten Längsgräben (4) und am Boden der Längsgräben (4) angeordnet sind,
- bei dem eine zweite dielektrische Schicht (10) erzeugt wird,
- bei dem durch Abscheiden und anisotropes Ätzen einer zweiten Polysiliziumschicht (11) Kontrollgates (11') und quer zu den Zeilen verlaufende Wortleitungen (11') erzeugt werden, die jeweils mit den Kontrollgates von entlang unterschiedlichen Zeilen angeordneten MOS-Transistoren verbunden sind,
- bei dem die zweite dielektrische Schicht (10) und die erste Polysiliziumstruktur (6') durch anisotropes Ätzen entsprechend den Wortleitungen (11') strukturiert werden,
- bei dem eine Source/Drain-Implantation für die MOS-Transistoren durchgeführt wird, bei der die Wortleitungen (11') als Maske wirken.

6. Verfahren nach Anspruch 5,
- bei dem zur selbstjustierten Strukturierung der ersten Polysiliziumschicht (6) durch Abscheiden und zum Halbleitersubstrat (1) selektives, anisotropes Ätzen einer ersten Hilfsschicht Spacer (7) an den an den Flanken der Längsgräben (4) angeordneten Teilen der ersten Polysiliziumschicht (6) gebildet werden,
- bei dem auf freiliegenden Teilen der ersten Polysiliziumschicht (6) selektiv eine zweite Hilfsschicht (8) erzeugt wird, zu der die erste Hilfsschicht (7) und die erste Polysiliziumschicht (6) selektiv ätzbar sind,
- bei dem die Spacer (7) selektiv zur zweiten Hilfsschicht (8) entfernt werden,
- bei dem die erste Polysiliziumstruktur (6') durch Ätzen der ersten Polysiliziumschicht (6) unter Verwendung der zweiten Hilfsschicht (8) als Ätzmaske gebildet wird,
- bei dem die zweite Hilfsschicht (8) entfernt wird.

7. Verfahren nach Anspruch 6,
bei dem die zweite Hilfsschicht (8) aus thermischem SiO₂ und die erste Hilfsschicht aus Si₃N₄ oder aus SiO₂, das zu thermischem SiO₂ selektiv ätzbar ist, gebildet werden.

8. Verfahren nach Anspruch 5,
bei dem die Längsgräben (4) durch kombiniertes anisotropes und isotropes Ätzen gebildet werden.

## Claims (Claims for the following Contracting State(s): IT)

1. Electrically writable and erasable read-only memory cell arrangement,
- in which a multiplicity of individual memory cells are provided in a region (2), doped by a first conductivity type, of a semiconductor substrate (1),
- in which the region (2) doped by the first conductivity type is insulated from the semiconductor substrate (1),
- in which the memory cells are in each case arranged in rows which run essentially parallel,
- in which longitudinal trenches (4) which run essentially parallel to the rows are provided in a main area (3) of the semiconductor substrate (1),
- in which the rows are in each case arranged alternately on the main area (3) between adjacent longitudinal trenches (4) and on the bottom of the longitudinal trenches (4),
- in which the memory cells each comprise at least one MOS transistor having source/drain regions (12) which are doped by a second conductivity type opposite to the first, a first dielectric (5), a floating gate (6"), a second dielectric (10) and a control gate (11'),
- in which the MOS transistors of memory cells arranged along a row are interconnected in series,
- in which word lines (11'), which are each connected to the control gates on MOS transistors arranged along different rows, run transversely with respect to the rows.

2. Read-only memory cell arrangement according to Claim 1,
in which a highly doped p⁺-doped layer (2a) is provided for the purpose of insulation between adjacent rows at the level of half the trench depth.

3. Read-only memory cell arrangement according to Claim 1 or 2,
- in which interconnected source/drain regions of MOS transistors which are adjacent along a row are constructed as a coherent doped region (12) in the semiconductor substrate (1),
- in which each row has two connections, between which the MOS transistors arranged in the row are interconnected in series.

4. Read-only memory cell arrangement according to one of Claims 1 to 3,
in which the sides of the longitudinal trenches (4) have bulges in the region of the trench bottom which are filled with insulating material.

5. Read-only memory cell arrangement according to one of Claims 1 to 4,
- in which the semiconductor substrate (1) has monocrystalline silicon at least in the region of the region (2) doped by the first conductivity type,
- in which the first dielectric (5) is constructed in each case as an SiO₂ layer,
- in which the second dielectric (10) in each case contains SiO₂ and/or Si₃N₄,
- in which the floating gate (6") and the control gate (11') each contain doped polysilicon.

6. Method for the production of an electrically writable and erasable read-only memory cell arrangement,
- in which a region (2) which is doped by a first conductivity type and is insulated from a semiconductor substrate (1) is produced in a main area (3) of the semiconductor substrate (1),
- in which longitudinal trenches (4) which run essentially parallel are etched in the main area (3) within the region (2) doped by the first conductivity type,
- in which a multiplicity of memory cells arranged in rows are produced, which memory cells each comprise at least one MOS transistor having source/drain regions (12) which are doped by a second conductivity type opposite to the first, a first dielectric (5), a floating gate (6"), a second dielectric (10) and a control gate (11'), the rows being arranged alternately on the main area (3) between adjacent longitudinal trenches (4) and on the bottom of the longitudinal trenches (4), and the MOS transistors of memory cells arranged along a row being interconnected in series,
- in which a first dielectric layer (5) is produced,
- in which a first doped polysilicon layer (6) is produced and structured in such a way that strip-like first polysilicon structures (6') are produced which are arranged parallel to the longitudinal trenches (4) in each case on the main area (3) between adjacent longitudinal trenches (4) and on the bottom of the longitudinal trenches (4),
- in which a second dielectric layer (10) is produced,
- in which control gates (11') and word lines (11') which run transversely with respect to the rows and are each connected to the control gates of MOS transistors arranged along different rows are produced by deposition and anisotropic etching of a second polysilicon layer (11),
- in which the second dielectric layer (10) and the first polysilicon structure (6') are structured by anisotropic etching corresponding to the word lines (11'),
- in which source/drain implantation is effected for the MOS transistors, during which the word lines (11') act as a mask.

7. Method according to Claim 6,
- in which, for the self-aligned structuring of the first polysilicon layer (6), spacers (7) are formed on those parts of the first polysilicon layer (6) which are arranged on the sides of the longitudinal trenches (4), by deposition and anisotropic etching, which is selective with respect to the semiconductor substrate (1), of a first auxiliary layer,
- in which a second auxiliary layer (8) is produced selectively on exposed parts of the first polysilicon layer (6), it being possible to etch the first auxiliary layer (7) and the first polysilicon layer (6) selectively with respect to the said second auxiliary layer,
- in which the spacers (7) are removed selectively with respect to the second auxiliary layer (8),
- in which the first polysilicon structure (6') is formed by etching the first polysilicon layer (6) while using the second auxiliary layer (8) as an etching mask,
- in which the second auxiliary layer (8) is removed.

8. Method according to Claim 7,
in which the second auxiliary layer (8) is formed from thermal SiO₂ and the first auxiliary layer is formed from Si₃N₄ or from SiO₂ which can be etched selectively with respect to thermal SiO₂.

9. Method according to one of Claims 5 to 8,
- in which the longitudinal trenches (4) are produced in such a way that their sides have bulges in the region of the trench bottom, by virtue of which bulges the width of the trench (4) is greater in the region of the trench bottom than in the region of the main area (3),
- in which the bulges are filled with insulating material.

10. Method according to Claim 9,
in which the longitudinal trenches (4) are formed by combined anisotropic and isotropic etching.

## Claims (Claims for the following Contracting State(s): DE, FR, GB)

1. Electrically writable and erasable read-only memory cell arrangement,
- in which a multiplicity of individual memory cells are provided in a region (2), doped by a first conductivity type, of a semiconductor substrate (1),
- in which the region (2) doped by the first conductivity type is insulated from the semiconductor substrate (1),
- in which the memory cells are in each case arranged in rows which run essentially parallel,
- in which longitudinal trenches (4) which run essentially parallel to the rows are provided in a main area (3) of the semiconductor substrate (1), and their sides have bulges in the region of the trench bottom which are filled with insulating material,
- in which the rows are in each case arranged alternately on the main area (3) between adjacent longitudinal trenches (4) and on the bottom of the longitudinal trenches (4),
- in which the memory cells each comprise at least one MOS transistor having source/drain regions (12) which are doped by a second conductivity type opposite to the first, a first dielectric (5), a floating gate (6"), a second dielectric (10) and a control gate (11'),
- in which the MOS transistors of memory cells arranged along a row are interconnected in series,
- in which word lines (11'), which are each connected to the control gates on MOS transistors arranged along different rows, run transversely with respect to the rows.

2. Read-only memory cell arrangement according to Claim 1,
in which a highly doped p⁺-doped layer (2a) is provided for the purpose of insulation between adjacent rows at the level of half the trench depth.

3. Read-only memory cell arrangement according to Claim 1 or 2,
- in which interconnected source/drain regions of MOS transistors which are adjacent along a row are constructed as a coherent doped region (12) in the semiconductor substrate (1),
- in which each row has two connections, between which the MOS transistors arranged in the row are interconnected in series.

4. Read-only memory cell arrangement according to one of Claims 1 to 3,
- in which the semiconductor substrate (1) has monocrystalline silicon at least in the region of the region (2) doped by the first conductivity type,
- in which the first dielectric (5) is constructed in each case as an SiO₂ layer,
- in which the second dielectric (10) in each case contains SiO₂ and/or Si₃N₄,
- in which the floating gate (6") and the control gate (11') each contain doped polysilicon.

5. Method for the production of an electrically writable and erasable read-only memory cell arrangement,
- in which a region (2) which is doped by a first conductivity type and is insulated from a semiconductor substrate (1) is produced in a main area (3) of the semiconductor substrate (1),
- in which longitudinal trenches (4) which run essentially parallel are etched in the main area (3) within the region (2) doped by the first conductivity type,
- in which the longitudinal trenches (4) are produced in such a way that their sides have bulges in the region of the trench bottom, by virtue of which bulges the width of the trench (4) is greater in the region of the trench bottom than in the region of the main area (3),
- in which the bulges are filled with insulating material,
- in which a multiplicity of memory cells arranged in rows are produced, which memory cells each comprise at least one MOS transistor having source/drain regions (12) which are doped by a second conductivity type opposite to the first, a first dielectric (5), a floating gate (6"), a second dielectric (10) and a control gate (11'), the rows being arranged alternately on the main area (3) between adjacent longitudinal trenches (4) and on the bottom of the longitudinal trenches (4), and the MOS transistors of memory cells arranged along a row being interconnected in series,
- in which a first dielectric layer (5) is produced,
- in which a first doped polysilicon layer (6) is produced and structured in such a way that strip-like first polysilicon structures (6') are produced which are arranged parallel to the longitudinal trenches (4) in each case on the main area (3) between adjacent longitudinal trenches (4) and on the bottom of the longitudinal trenches (4),
- in which a second dielectric layer (10) is produced,
- in which control gates (11') and word lines (11') which run transversely with respect to the rows and are each connected to the control gates of MOS transistors arranged along different rows are produced by deposition and anisotropic etching of a second polysilicon layer (11),
- in which the second dielectric layer (10) and the first polysilicon structure (6') are structured by anisotropic etching corresponding to the word lines (11'),
- in which source/drain implantation is effected for the MOS transistors, during which the word lines (11') act as a mask.

6. Method according to Claim 5,
- in which, for the self-aligned structuring of the first polysilicon layer (6), spacers (7) are formed on those parts of the first polysilicon layer (6) which are arranged on the sides of the longitudinal trenches (4), by deposition and anisotropic etching, which is selective with respect to the semiconductor substrate (1), of a first auxiliary layer,
- in which a second auxiliary layer (8) is produced selectively on exposed parts of the first polysilicon layer (6), it being possible to etch the first auxiliary layer (7) and the first polysilicon layer (6) selectively with respect to the said second auxiliary layer,
- in which the spacers (7) are removed selectively with respect to the second auxiliary layer (8),
- in which the first polysilicon structure (6') is formed by. etching the first polysilicon layer (6) while using the second auxiliary layer (8) as an etching mask,
- in which the second auxiliary layer (8) is removed.

7. Method according to Claim 6,
in which the second auxiliary layer (8) is formed from thermal SiO₂ and the first auxiliary layer is formed from Si₃N₄ or from SiO₂ which can be etched selectively with respect to thermal SiO₂.

8. Method according to Claim 5,
in which the longitudinal trenches (4) are formed by combined anisotropic and isotropic etching.

## Revendications (Revendications pour l'(les) Etat(s) contractant(s) suivant(s): IT)

1. Dispositif à cellules de mémoire morte, dans lequel on peut écrire et effacer par voie électrique,
- dans lequel il est prévu une pluralité de cellules de mémoires individuelles dans un domaine (2) d'un substrat (1) semi-conducteur qui est dopé suivant un premier type de conductivité,
- dans lequel le domaine (2) dopé suivant un premier type de conductivité est isolé par rapport au substrat (1) semi-conducteur,
- dans lequel les cellules de mémoire sont disposées respectivement en des lignes sensiblement parallèles.
- dans lequel il est prévu dans une surface (3) principale du substrat (1) semi-conducteur des sillons (4) longitudinaux qui sont sensiblement parallèles aux lignes,
- dans lequel les cellules sont disposées respectivement en altemance sur la surface (3) principale entre des sillons (4) longitudinaux voisins et sur le fond des sillons (4) longitudinaux,
- dans lequel les cellules de mémoire comprennent respectivement au moins un transistor MOS ayant des zones (12) source/drain dopées suivant un deuxième type de conductivité opposé au premier type, un premier diélectrique (5), une grille (6") flottante, un deuxième diélectrique (10) et une grille (11') de contrôle,
- dans lequel les transistors MOS de cellules de mémoire disposées le long d'une ligne sont montés en série,
- dans lequel il s'étend transversalement aux lignes des conducteurs (11') de mots qui sont reliés respectivement aux grilles de contrôle sur des transistors MOS disposés dans des lignes différentes.

2. Dispositif de cellules de mémoire morte suivant la revendication 1, dans lequel il est prévu pour l'isolation entre des lignes voisines au niveau des demi-profondeurs des sillons une couche (2a) très dopée à dopage p⁺.

3. Dispositif de cellules de mémoire morte suivant la revendication 1 ou 2,
- dans lequel des zones de source/drain reliées entre elles de transistors MOS voisins le long d'une ligne sont constituées sous la forme de zone (12) dopée d'un seul tenant dans le substrat (1) semi-conducteur,
- dans lequel chaque ligne comporte deux bornes entre lesquelles les transistors MOS disposés dans la ligne sont montés en série.

4. Dispositif de cellules de mémoire morte suivant l'une des revendications 1 à 3, **caractérisé en ce que** les flancs des sillons longitudinaux comportent, dans la région du fond des sillons, des indentations qui sont emplies de matière isolante.

5. Dispositif de cellules de mémoire morte suivant l'une des revendications 1 à 4,
- dans lequel le substrat (1) semi-conducteur comporte, au moins dans la région de la zone (2) dopée suivant le premier type de conductivité, du silicium monocristallin,
- dans lequel le premier diélectrique (5) est constitué respectivement sous la forme d'une couche de SiO₂,
- dans lequel le deuxième diélectrique (10) contient respectivement du SiO₂ et/ou du Si₃N₄,
- dans lequel dans lequel la grille (6") flottante et la grille (11') de contrôle contiennent respectivement du polysilicium dopé.

6. Procédé de fabrication d'un dispositif à cellules de mémoire morte, dans lequel on peut écrire et effacer par voie électrique,
- dans lequel on produit dans une surface (3) principale d'un substrat (1) semi-conducteur une zone (2) dopée d'un premier type de conductivité qui est isolée vis à vis du substrat (1) semi-conducteur,
- dans lequel on ménage par attaque chimique dans la surface (3) principale, dans la zone (2) dopée suivant le premier type de conductivité, des sillons (4) longitudinaux qui sont sensiblement parallèles,
- dans lequel on produit une pluralité de cellules de mémoire disposées en lignes qui comprennent respectivement au moins un transistor MOS ayant des zones (12) de source/drain dopées suivant un deuxième type de conductivité opposé au premier, un premier diélectrique (5), une grille (6") flottante, un deuxième diélectrique (10) et une grille (11') de contrôle, les lignes étant disposées en alternance sur la surface (3) principale entre des sillons (4) longitudinaux voisins et au fond des sillons (4) longitudinaux et les transistors MOS de cellules de mémoire disposées le long d'une ligne étant montés en série,
- dans lequel on produit une première couche (5) diélectrique,
- dans lequel on produit et structure une première couche (6) de polysilicium dopée de façon à créer des premières structures (6') de polysilicium en forme de bandes qui sont disposées parallèlement aux sillons (4) longitudinaux, respectivement sur la surface (3) principale entre des sillons (4) longitudinaux voisins, et sur le fond des sillons (4) longitudinaux,
- dans lequel on produit une deuxième couche (10) diélectrique,
- dans lequel par dépôt et attaque chimique anisotrope d'une deuxième couche (11) de polysilicium on produit des grilles (11') de contrôle et des conducteurs (11') de mots s'étendant transversalement aux lignes et reliés respectivement aux grilles de contrôle de transistors MOS disposés le long de lignes différentes,
- dans lequel on structure la deuxième couche (10) diélectrique et la première structure (6') en polysilicium par attaque chimique anisotrope conformément aux conducteurs (11') de mots,
- dans lequel on effectue une implantation source/drain pour les transistors MOS en se servant des conducteurs (11') de mots comme masque.

7. Procédé suivant la revendication 6,
- dans lequel on forme, pour la structuration avec autoalignement de la première couche (6) de polysilicium par dépôt et pour l'attaque chimique anisotrope sélective par rapport au substrat (1) semi-conducteur d'une première couche auxiliaire, des espaceurs sur les parties de la première couche (6) en polysilicium qui sont disposés sur les flancs des sillons (4) longitudinaux,
- dans lequel on produit sur des parties mises à nu de la première couche (6) de polysilicium sélectivement une deuxième couche (8) auxiliaire par rapport à laquelle la première couche (7) auxiliaire et la première : couche (6) en polysilicium peuvent être attaquées chimiquement de manière sélective,
- dans lequel on élimine les espaceurs (7) sélectivement par rapport à la deuxième couche (8) auxiliaire,
- dans lequel on forme la première structure (6') en polysilicium par attaque chimique de la première couche (6) en polysilicium en utilisant la deuxième couche (8) auxiliaire en tant que masque d'attaque chimique,
- dans lequel on élimine la deuxième couche (8) auxiliaire.

8. Procédé suivant la revendication 7,
dans lequel on forme la deuxième couche (8) auxiliaire en SiO₂ thermique et la première couche auxiliaire en Si₃N₄ ou en SiO₂ qui peut être attaquée chimiquement d'une manière sélective par rapport au SiO₂ thermique.

9. Procédé suivant l'une des revendications 5 à 8, dans lequel on produit les sillons (4) longitudinaux de façon que leurs flancs présentent dans la région du fond des sillons des indentations par lesquelles la largeur du sillon (4) dans la région du fond du sillon est plus grande que dans la région de la surface (3) principale.

10. Procédé suivant la revendication 9,
dans lequel on forme les silions (4) longitudinaux par attaque chimique anisotrope et isotrope combinée.

## Revendications (Revendications pour l'(les) Etat(s) contractant(s) suivant(s): DE, FR, GB)

1. Dispositif à cellules de mémoire morte, dans lequel on peut écrire et effacer par voie électrique,
- dans lequel il est prévu une pluralité de cellules de mémoires individuelles dans un domaine (2) d'un substrat (1) semi-conducteur qui est dopé suivant un premier type de conductivité,
- dans lequel le domaine (2) dopé suivant un premier type de conductivité est isolé par rapport au substrat (1) semi-conducteur,
- dans lequel les cellules de mémoire sont disposées respectivement en des lignes sensiblement parallèles,
- dans lequel il est prévu dans une surface (3) principale du substrat (1) semi-conducteur des sillons (4) longitudinaux qui sont sensiblement parallèles aux lignes et dont les flancs comportent, dans la région du fond des sillons, des indentations qui sont emplies de matière isolante,
- dans lequel les cellules sont disposées respectivement en altemance sur la surface (3) principale entre des sillons (4) longitudinaux voisins et sur le fond des sillons (4) longitudinaux,
- dans lequel les cellules de mémoire comprennent respectivement au moins un transistor MOS ayant des zones (12) source/drain dopées suivant un deuxième type de conductivité opposé au premier type, un premier diélectrique (5), une grille (6") flottante, un deuxième diélectrique (10) et une grille (11') de contrôle,
- dans lequel les transistors MOS de cellules de mémoire disposées le long d'une ligne sont montés en série,
- dans lequel il s'étend transversalement aux lignes des conducteurs (11') de mots qui sont reliés respectivement aux grilles de contrôle sur des transistors MOS disposés dans des lignes différentes.

2. Dispositif de cellules de mémoire morte suivant la revendication 1, dans lequel il est prévu pour l'isolation entre des lignes voisines au niveau des demi-profondeurs des sillons une couche (2a) très dopée à dopage p⁺.

3. Dispositif de cellules de mémoire morte suivant la revendication 1 ou 2,
- dans lequel des zones de source/drain reliées entre elles de transistors MOS voisins le long d'une ligne sont constituées sous la forme de zone (12) dopée d'un seul tenant dans le substrat (1) semi-conducteur,
- dans lequel chaque ligne comporte deux bornes entre lesquelles les transistors MOS disposés dans la ligne sont montés en série.

4. Dispositif de cellules de mémoire morte suivant l'une des revendications 1 à 3,
- dans lequel le substrat (1) semi-conducteur comporte, au moins dans la région de la zone (2) dopée suivant le premier type de conductivité, du silicium monocristallin,
- dans lequel le premier diélectrique (5) est constitué respectivement sous la forme d'une couche de SiO₂,
- dans lequel le deuxième diélectrique (10) contient respectivement du SiO₂ et/ou du Si₃N₄,
- dans lequel dans lequel la grille (6") flottante et la grille (11') de contrôle contiennent respectivement du polysilicium dopé.

5. Procédé de fabrication d'un dispositif à cellules de mémoire morte, dans lequel on peut écrire et effacer par voie électrique,
- dans lequel on produit dans une surface (3) principale d'un substrat (1) semi-conducteur une zone (2) dopée d'un premier type de conductivité qui est isolée vis à vis du substrat (1) semi-conducteur,
- dans lequel on ménage par attaque chimique dans la surface (3) principale, dans la zone (2) dopée suivant le premier type de conductivité, des sillons (4) longitudinaux qui sont sensiblement parallèles,
- dans lequel on produit les sillons (4) longitudinaux de façon que leurs flancs présentent dans la région du fond des sillons des indentations par lesquelles la largeur du sillon (4) dans la région du fond du sillon est plus grande que dans la région de la surface (3) principale,
- dans lequel on emplit les indentations de matière isolante,
- dans lequel on produit une pluralité de cellules de mémoire disposées en lignes qui comprennent respectivement au moins un transistor MOS ayant des zones (12) de source/drain dopées suivant un deuxième type de conductivité opposé au premier, un premier diélectrique (5), une grille (6") flottante, un deuxième diélectrique (10) et une grille (11') de contrôle, les lignes étant disposées en alternance sur la surface (3) principale entre des sillons (4) longitudinaux voisins et au fond des sillons (4) longitudinaux et les transistors MOS de cellules de mémoire disposées le long d'une ligne étant montés en série,
- dans lequel on produit une première couche (5) diélectrique,
- dans lequel on produit et structure une première couche (6) de polysilicium dopée de façon à créer des premières structures (6') de polysilicium en forme de bandes qui sont disposées parallèlement aux sillons (4) longitudinaux, respectivement sur la surface (3) principale entre des sillons (4) longitudinaux voisins, et sur le fond des sillons (4) longitudinaux,
- dans lequel on produit une deuxième couche (10) diélectrique,
- dans lequel par dépôt et attaque chimique anisotrope d'une deuxième couche (11) de polysilicium on produit des grilles (11') de contrôle et des conducteurs (11') de mots s'étendant transversalement aux lignes et reliés respectivement aux grilles de contrôle de transistors MOS disposés le long de lignes différentes,
- dans lequel on structure la deuxième couche (10) diélectrique et la première structure (6') en polysilicium par attaque chimique anisotrope conformément aux conducteurs (11') de mots,
- dans lequel on effectue une implantation sourceldrain pour les transistors MOS en se servant des conducteurs (11') de mots comme masque.

6. Procédé suivant la revendication 5,
- dans lequel on forme, pour la structuration avec autoalignement de la première couche (6) de polysilicium par dépôt et pour l'attaque chimique anisotrope sélective par rapport au substrat (1) semi-conducteur d'une première couche auxiliaire, des espaceurs sur les parties de la première couche (6) en polysilicium qui sont disposés sur les flancs des sillons (4) longitudinaux,
- dans lequel on produit sur des parties mises à nu de la première couche (6) de polysilicium sélectivement une deuxième couche (8) auxiliaire par rapport à laquelle la première couche (7) auxiliaire et la première couche (6) en polysilicium peuvent être attaquées chimiquement de manière sélective,
- dans lequel on élimine les espaceurs (7) sélectivement par rapport à la deuxième couche (8) auxiliaire,
- dans lequel on forme la première structure (6') en polysilicium par attaque chimique de la première couche (6) en polysilicium en utilisant la deuxième couche (8) auxiliaire en tant que masque d'attaque chimique,
- dans lequel on élimine la deuxième couche (8) auxiliaire.

7. Procédé suivant la revendication 6,
dans lequel on forme la deuxième couche (8) auxiliaire en SiO₂ thermique et la première couche auxiliaire en Si₃N₄ ou en SiO₂ qui peut être attaquée chimiquement d'une manière sélective par rapport au SiO₂ thermique.

8. Procédé suivant la revendication 5,
dans lequel on forme les sillons (4) longitudinaux par attaque chimique anisotrope et isotrope combinée.
